# EUROPÄISCHE PATENTSCHRIFT

(11) **EP 1 739 804 B1**
(45) Veröffentlichungstag und Bekanntmachung des Hinweises auf die Patenterteilung: **18.11.2009**
(21) Anmeldenummer: 05105999.6
(22) Anmeldetag: 01.07.2005
(51) Int. Cl.: H02G 5/10, H01R 25/14, H05K 7/20

(54) **Tragschiene zur stromleitenden Halterung eines oder mehrerer elektrischer Geräte**
Rail for electrically conductive support of one or more electrical devices
Rail de support conducteur de courant d'un ou de plusieurs appareils électriques

(43) Veröffentlichungstag der Anmeldung: 03.01.2007
(73) Patentinhaber: Baumüller Anlagen-Systemtechnik GmbH & Co. KG, 90482 Nürnberg (DE)
(72) Erfinder: Strunz, Ulrich Dr., 90542 Eckental (DE)
(74) Vertreter: Götz, Georg Alois

(56) Entgegenhaltungen:
- EP-A- 0 407 167
- EP-A- 0 828 323
- DE-A1- 1 440 838
- GB-A- 630 097
- US-A- 5 459 810

## Beschreibung

Die Erfindung betrifft eine Anordnung einer Tragschiene mit wenigstens einem daran gehalterten elektrischen Gerät gemäß Oberbegriff des Anspruchs 1.

Bei der Realisierung von Elektronik und Leistungseinheiten in Anreihtechnik (vgl. z. B. BAUMÜLLER BUS-Reihe) stellt sich das Problem der Verbindung der einzelnen elektrischen Komponenten mit Signal- und Leistungsbussen. Wünschenswert ist hierbei eine Lösung, die eine möglichst flexible Busbelegung ermöglicht und dabei sowohl vom Platzbedarf als auch vom Montageaufwand her optimiert ist. Im Stand der Technik werden vielfach individualisierte Montage- und Installationssysteme verwendet, die hinsichtlich des Montage-, Installations- und Verkabelungsaufwands keine befriedigende Lösung bieten. So werden elektrische Verbindungen zum Beispiel mittels angeschraubter Kupferschienen an der Front- oder Oberseite der elektrischen/elektronischen Einzelkomponenten hergestellt. Zusätzlich zum hierdurch bedingten hohen Installations- und Montageaufwand ergibt sich die Problematik, dass zum Austauschen einzelner Komponenten die gesamte Anlage spannungslos geschaltet werden muss. Außerdem können damit nur elektrisch betriebene Busse an die Einzelkomponenten angebunden werden.

US-A-5 459 810 offenbart ein einstellbares Platten- und Montagesystem für ein Kühl- oder Heizsystem, bei dem Wärmetauscherplatten auf einer Oberfläche, wie etwa einer Wandung oder einer Decke eines Gehäuses, angebracht sind. Das Kühl- oder Heizsystem kann mittels Wasser als Wärmeübertragungsmedium oder mittels Heizspulen betrieben sein, wobei letztere mit elektrischer Energie gespeist werden. Das Montagesystem besteht aus einem Halteelement, welches durch Befestigungsmittel mit Wand oder Decke verbunden werden kann, einer Halteklammer, die gleichzeitig als Führung bzw, Bündelung für elektrische Leitungen dienen kann sowie einem Konsolenelement aus einem thermisch leitfähigen Material, vorzugsweise Aluminium, das mit integrierten Leitungen zum Transport des Wassers, das für die Heizzwecke verwendet wird, ausgebildet ist. Die Befestigungsklammer weist auskragende Arme auf, die in entsprechende Befestigungsnuten auf der Innenseite der Konsolen eingreift. Zur Montage wird zunächst das Halteelement am gewünschten Platz im Wand- oder Deckenbereich befestigt, dann wird das mit der Befestigungsklammer verbundene Panelelement in die Halteschiene eingedrückt, wobei die Befestigungsklammer mit an ihr vorhandenen Befestigungselementen in komplementäre Elemente des Halteelements eingreift. Um die Wärmetransportkapazität zu erhöhen, wird in Figur 20 und 21 der genannten Fundstelle vorgeschlagen, zwischen zwei Montageplatten einen Verbindungsstreifen aus Aluminium anzuordnen, der entsprechend dem erwünschten Wärmetransporteffekt um so breiter ausgeführt wird. Ferner wird dafür eine Anwendung als Deckenabdeckung zum Einsatz als Kühlsystem für Klimaanlagen in geschlossenen Räumen angegeben.

GB-A-630 097 beschreibt eine elektrische Leitungs- und Traganordnung Leiter/Trägerstreifen, deren Inneres mit längsverlaufenden Kühlkanälen durchsetzt ist, welche vollständig von einem isolierenden Streifenmaterial umgeben sind. Die Kühlkanäle verlaufen dabei in nächster Nähe zu den ebenfalls in dem Streifenmaterial eingebetteten, elektrischen Leitern. So können die Kühlkanäle die Temperatur des Streifenmaterials reduzieren, das von den stromdurchflossenen, inneren Leitern erwärmt wird. Auf dem isolierenden Streifenmaterial der Leiter/Trägerschiene ist eine extern hergestellte Geräteeinheit aufgebracht, welche mit Kontaktmitteln das isolierende Streifenmaterial bis zu den elektrischen Leitern durchsetzt.

EP-A-828 323 offenbart ein integriertes Sammelschienensystem, worauf elektrische Verbraucherabzweige aufsetzbar sind. Über eine Anzahl erster Kammern werden erste Leiterschienen zur Energieübertragung und über eine Anzahl von zweiten Kammern zweite Leiterschienen zur Hilfsenergieübertragung und über eine dritte Kammer ein Leiterelement zur Kommunikationsübertragung aufgenommen. Die gezeichneten Kupferprofile sind mit Hohlräumen gestaltet, wodurch Luft strömen könnte.

EP-A-0 407 167 offenbart eine Busschiene für eine elektrische Stromversorgung mit inneren Hohlleitern, welche von einem rohrförmigen Außenleiter umfasst sind. Die Hohlräume der inneren Hohlleiter dienen dem Durchfluss eines Kühlmediums. Dadurch soll eine effektive Kühlung der bestromten Hohlleiter erreichbar sein. Ähnlich offenbart DE-A-1 440 838 eine Stromschiene mit vergrößerter Oberfläche, wobei die Stromschiene als Hohlleiter ausgeführt ist, dessen innere Begrenzungsflächen Nuten oder Rillen aufweisen.

Aus DE-A-103 51 479 A1 ist ein Gerätesystem bekannt, bei welchem eine Mehrzahl elektrischer Geräte auf einer als Hutschiene ausgebildeten Tragschiene lösbar angeordnet ist. Darin ist eine. Busleitung bzw. elektrische Sammelschiene angeordnet, deren einzelne Buselemente an ihrer Oberseite Kontaktflächen aufweisen. Diesen sind elektrische Kontaktflächen der Geräte oder Bauteile zugeordnet, welche an der hutförmigen Tragschiene zu haltern sind. Diese ist als Teil aus einem Stück ausgebildet, worin die einzelnen Buselemente in Serie aneinander anschließbar aufgenommen sind.

In DE-C-195 24 123 ist eine hutförmige Tragschiene zur Kopplung mit Steckern und/oder elektrischen Bauteilen beschrieben. Ein Grundkörper aus isolierendem Material ist in die Tragschiene eingelegt. Um daran an jeder Stelle mit einem Stecker oder einem sonstigen Bauteil koppeln zu können, weist der Grundkörper eine Mehrzahl von in Schienenlängsrichtung verlaufenden Anschlusselementen auf.

In US-A-3 354 261 ist ein elektrisches Buselement in der Form eines rechteckigen Hohlleiters beschrieben, wobei in den Eckbereichen Kühlkanäle in Leiterlängsrichtung ausgebildet sind. In einem Wandungsbereich sind Montagemittel vorgesehen, um den aus mehreren Elementen zusammensetzbaren Bus auf Isolationsstationen zu befestigen. Die Kühlkanäle der einzelnen Buselemente werden dabei in Längsrichtung fluchtend aneinandergefügt und sind in den Eckbereichen derart positioniert, dass der in den Eckbereichen besonders stark auftretende Stromfluss gekühlt wird. In JP-A-2000231832 ist eine Stromversorgungsschiene mit Kühlkanälen beschrieben, die ebenfalls in den Leitungsschienen integriert sind. DE-U-87 15 620 beschreibt Stromrohre, die der Leitung starker Ströme mit hoher Stromdichte dienen und deshalb von Kühlfüssigkeit durchströmt werden. Gemäß DE-U-90 15 107.0 werden parallele Stromschienen in einem Gehäuse angeordnet, durch welches mittels mehrerer, in Längsrichtung versetzt angeordneter Lüfter Kühlluftströme erzeugt werden. Nach DE-C-31 03 433 werden bei einem Sammelschienen-System mit Stromschienen für Hoch- und Mittelspannungsschaltanlagen die einzelnen Stromschienen jeweils mit mehreren, längs hintereinander angeordneten Kühlkörpern in C-Form versehen.

Der Erfindung liegt die Aufgabe zugrunde, bei einer Tragschiene oder einem modularen Tragschienensystem mit elektrischem Bus eine Steigerung der Effizienz bei der Montage und der Installation insbesondere hinsichtlich der Abfuhr von Verlustleistungen zu erhöhen. Zur Lösung wird auf die im Patentanspruch 1 angegebene Tragschienen-Geräte-Anordnung verwiesen. Optionale, vorteilhafte Ausgestaltungen dieser Erfindungsidee ergeben sich aus den abhängigen Ansprüchen, der Beschreibungen und den Zeichnungen.

Durch die erfindungsgemäße Integration eines Systems zur Wärmezu- und/oder -abfuhr können größere Abwärmemengen abgeführt werden, welche beispielsweise von Leistungselektronik-Komponenten mit spürbarer Verlustleistung herrühren. Mit der Erfindung wird der Vorteil erzielt, die parallelen Strukturen von Eingangs- und Ausgangsleitungen eines Sammelschienensystems (Bus) zur Abfuhr von Verlustleistungen der zu halternden elektrischen Geräte nützen zu können.

Gemäß einer optionalen Weiterbildung ist die Kühleinrichtung mit einem flachen Kühlkörper beispielsweise in Quader- oder Zylinderform versehen, der eine wärmeleitende Kühlwandung zur Anlage des oder der Geräte oder Bauteile aufweist. Die Kühlwandung kann entweder möglichst eben oder mit einer spezifischen Oberflächenstruktur gestaltet sein, womit eine komplementär strukturierte Kühlwandung des Geräts oder Bauteils in kraft- und/oder formschlüssigen Eingriff geraten kann. Auf der Basis der Erfindung lässt sich also ein thermisch leitfähiges Schienensystem schaffen, womit ein kosten- und bauraumoptimales Anreihsystem für elektrische Einheiten aufgebaut werden kann.

Der Gedanke der thermisch leitfähigen Tragschiene lässt sich noch durch eine optionale Ausbildung weiterführen, wonach ein oder mehrere Kühlkanäle vorgesehen sind, welche zu Verbindungselementen führen und die Kühleinrichtung oder etwaige Kühlkörper der Tragschiene durchsetzen. Damit wird dem elektrischen Bus gleichsam ein "thermischer Bus" hinzugefügt, indem mehrere Kühleinrichtungen parallel mit mindestens einem Kühlkanal thermisch gekoppelt werden.

Das erfindungsgemäße Kühlsystem zur Zu- und/oder Abfuhr von Wärme lässt sich aus einem vorzugsweise flach-ebenen Kühlkörper mit wärmeleitfähigem Material realisieren, der auf dem Schienen-Grundkörper montiert oder teilweise mit dem Grundkörper integriert ist. Dieser flächige Kühlkörper weist auf der dem Schienen-Grundkörper abgewandten Oberseite vorzugsweise eine flächige Oberfläche auf, auf die ein entsprechender Gegen-Kühlkörper einer elektrischen Einzelkomponente aufgesetzt werden kann. Durch die Wärmeleitfähigkeit der aneinanderliegenden Körper wird die in der elektrischen Einzelkomponente entstehende Wärme vorteilhaft abgeführt. Das System kann aber auch dazu benutzt werden, Einzelkomponenten bzw. Geräten Wärme zuzuführen. Zur weiteren Erhöhung der Effektivität des Wärmetransports können in einer vorteilhaften Weiterbildung der Erfindungsidee eine oder mehrere Kühlkanäle in den oder die Kühlkörper integriert werden, die zum Hindurchleiten eines wärmetransportierenden Mediums genutzt werden. Hierfür lassen sich je nach benötigter Wärmetransportkapazität zum Beispiel Luft oder Wasser nutzen. Je nach benötigter Wärmetransportleistung können diese Kühlkanäle entweder im wesentlichen parallel zur geometrischen Busrichtung geführt werden, oder in einer alternativen Ausführungsform zur Erhöhung der Wärmetransportleistung in Schleifen innerhalb des Körpers verlegt werden.

Nach einer weiteren optionalen Ausbildung sind die Verbindungselemente der Kühleinrichtung an unterschiedlichen, insbesondere gegenüberliegenden Seiten oder Abschnitten der Kühleinrichtung angeordnet, wobei die Verbindungsmittel einer Seite oder eines Abschnitts komplementär zu denen der anderen Seite oder des anderen Abschnitts ausgebildet sind. Damit lässt sich der Vorteil erzielen, dass eine oder mehrere Kühleinrichtungen einer Tragschiene an die eine oder mehreren Kühleinrichtungen einer benachbarten Tragschiene über zueinander komplementäre Verbindungsmittel zur Bildung eines modularen Tragschienensystems angeschlossen werden können. Eine Tragschiene bildet dabei ein Modul oder einen Teilabschnitt, der im Rahmen des modularen Tragschienensystems mit anderen Tragschienenmodulen koppelbar ist. Bei dieser Ausbildung lässt sich der "thermische Bus" über einzelne, aneinander gereihte Tragschienenmodule führen.

Zur Herstellung der thermischen Verbindungen zwischen der Kühleinrichtung der Tragschiene und dem elektrischen Gerät oder Bauteil liegen kraft- bzw. formschlüssige Verbindungen im Rahmen der Erfindung. Diese sind erfindungsgemäß durch Geräte-Befestigungsmittel realisiert, die dem Eingriff in das zu befestigende Gerät oder Bauteil dienen und dabei letztere in wärmeübertragender Verbindung oder Kopplung mit der Kühleinrichtung halten. Diese Befestigungsmittel können als Klammern, Schrauben oder Federn realisiert sein. Zur Verringerung der Wärmeübergangsstände lassen sich noch zusätzliche Mittel wie Wärmeleitpaste, sonstige, die Wärmeleitfähigkeit erhöhende Zusatzstoffe/Materialien sowie auch spezifische Form- und Oberflächengestaltungen einsetzen. Durch die Form- und/oder kraftschlüssige Anlage des Geräts oder Bauteiles an eine zugeordnete Kühlfläche auf der Tragschiene lässt sich eine ausreichende, thermische Anbindung gewährleisten.

Alternativ oder zusätzlich kann die Kühleinrichtung mit Anschlusselementen wie z. B. Verbindungsschläuche oder -rohre versehen sein, denen auf der Seite des anzuschließenden und zu kühlenden Geräts oder Bauteils entsprechende Anschlusselemente zugeordnet sind. Damit ist es z. B. denkbar, aus der Kühleinrichtung der Tragschiene Kühlflüssigkeit dem Gerät oder Bauteil zuzuführen.

Die Kühleinrichtung lässt sich auf der Tragschiene mit erhöhter Stabilität fixieren, wenn nach einer optionalen Ausbildung die Kühleinrichtung in einem Grundkörper der Tragschiene vertieft bzw. versenkt eingelassen ist. Dies ist insbesondere bei vertikaler Anordnung der Tragschiene zweckmäßig.

Vorteilhaft ist die Ausbildung oder Anbringung einer wärmeisolierenden Abdeckung auf der erfindungsgemäßen Tragschiene. Diese kann als Berührschutz den Bediener gegen hohe Temperaturen an den zu halternden Geräten oder Bauteilen oder am elektrischen Bus oder auch Kühlkörper schützen. Die Handhabungssicherheit für den Bediener wird erhöht.

Die Kombination von Übertragungsmöglichkeiten für unterschiedliche physikalische Größen wie elektrische und thermische Energie sowie Signale in einem oder mehreren Schienensystemen zur Anreihung von Einzelkomponenten bietet weitläufige Möglichkeiten. Neben den elektrischen Größen (Strom, Spannung) können auch digitale Daten oder sonstige Signale elektrisch, optisch, induktiv oder kapazitiv übertragen werden. Auf der Basis der Erfindung lassen sich insbesondere thermisch leitfähige Verbindungen zur Zu- oder Abfuhr von Wärme herstellen. Gemäß einer optionalen Erfindungsausbildung gehört zum Rahmen der Erfindung auch ein Kanalsystem zur Zuführung von Kühlluft. Andererseits sind auf der Basis der Erfindung auch angepasste Stecksysteme zum Austausch von flüssigen Kühlmedien zwischen der Systemschiene und der Wärmequelle oder -senke (Kühlkörper) eines einzelnen, anzureihenden Gerätemoduls denkbar.

Mit der Erfindung wird die Perspektive eines Tragschienensystems eröffnet, bei dem gleichzeitig mechanische, elektrische, thermische und/oder optische Verbindungen einzelner Geräte oder Bauteile untereinander ermöglicht ist und letztere gemeinschaftlich an gemeinsame Versorgungs- oder Entsorgungspunkte angeschlossen werden können.

Weitere Einzelheiten, Merkmale, Merkmalskombinationen und vorteilhafte Wirkungen auf der Basis der Erfindung ergeben sich aus der nachfolgenden Beschreibung bevorzugter Ausführungsbeispiele der Erfindung in Verbindung mit den folgenden Zeichnungen. Diese zeigen in:
- Figur 1: ein Tragschienenmodul für ein modulares Schienensystem mit verschiedenen elektrischen Bussen und einem Wärmetransportsystem ("thermischer Bus") in der Vorderansicht oder Draufsicht,
- Figur 2: die Tragschiene der Figur 1 in einer schmal- und stirnseitigen Querschnitts-Ansicht in Richtung II in Figur 1,
- Figur 3: eine Figur 2 entsprechende Querschnitts-Ansicht auf eine Anordnung der Tragschiene mit einem einzelnen, gehalterten Gerät, und
- Figur 4: eine Vorderansicht auf ein modulares Tragschienensystem mit mehreren aneinander gereihten Tragschienenmodulen sowie mehreren daran gehalterten Einzelgerätemodulen.

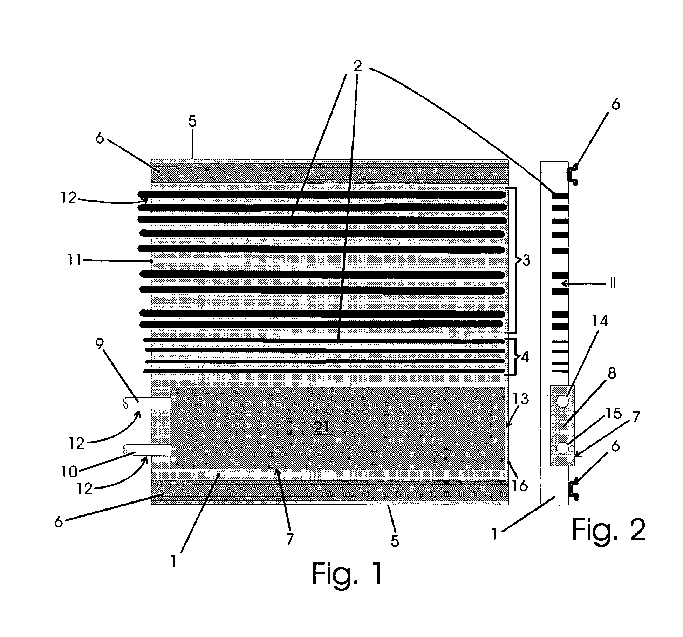

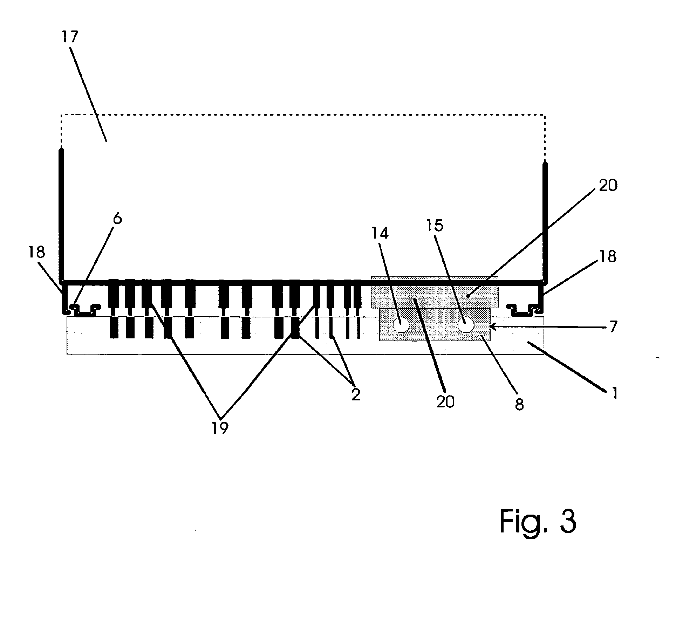

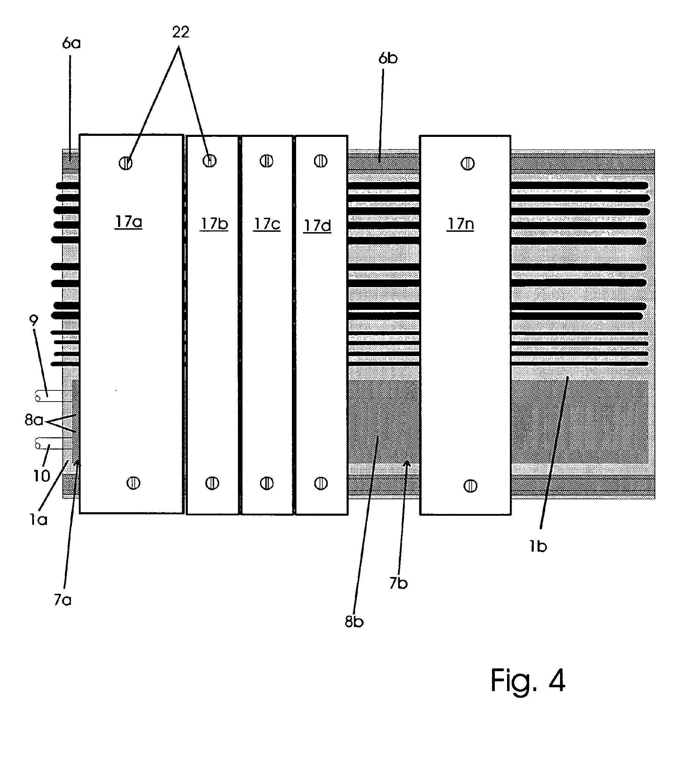

Gemäß Figur 1 wird die Tragschiene durch einen Grundkörper 1 ausgemacht, der aus nichtleitendem Material besteht. In den Grund- bzw. Schienenkörper 1 sind eine Mehrzahl geometrisch parallel verlaufender, elektrischer Verbindungsschienen 2 eingelassen. Diese lassen sich grob in einen Starkstrombus 3 zur Übertrag elektrischer Energie bzw. Leistung an die in Figur 3 und 4 dargestellten, elektrischen Geräte und einen Schwachstrombus 4 zur Übertragung von Informations-, Steuersignalen usw. ebenfalls an die genannten Geräte einteilen. Der Starkstrombus 3 umfasst Leitungen für einen Dreiphasen-Netzanschluss, zur Bildung eines Nullleiters, für elektrisches Erdpotential, für einen Zwischenkreis eines elektrischen Antriebssystems, Versorgungskleinspannungen usw. Der Schienen-Grundkörper 1 trägt im Bereich seiner Längsränder 5, die parallel zu den elektrischen Verbindungsschienen 2 verlaufen, an sich bekannte Hutschienen 6 zur mechanischen Befestigung der in Figur 3 und 4 schematisch dargestellten, elektrischen Geräte.

Wie aus Figur 2 ersichtlich, befindet sich zwischen dem Schwachstrombus 4 und einer der Hutschienen 6 eine Kühleinrichtung 7 mit etwa quaderförmigem, flachem Kühlkörper 8, der in den Schienengrundkörper 1 vertieft eingelassen ist. Er ist von (nicht gezeichneten) Kühlkanälen durchsetzt, welche mittels Anschlussstutzen 9 für Rücklauf und 10 für Vorlauf aus dem Kühlkörper 8 herausgeführt sind. Dabei überragen sie den nächstliegenden Querrand 11 des Schienen-Grundkörpers 1 (quer zu den Verbindungsschienen 2 bzw. zur Hutschiene 5) mit einem Überstand 12, um beispielsweise mit gemeinschaftlichen Versorgungs- und Entsorgungspunkten (nicht gezeichnet) oder mit einer Kühleinrichtung einer benachbarten Tragschiene über Steckanschlüsse zu kommunizieren. Zu dem selben Zweck ist die den Anschlussstutzen 9, 10 gegenüberliegende Stirnseite 13 mit buchsenartigen Stutzenaufnahmen 14, 15 versehen, in welche Anschlussstutzen einer benachbarten Kühleinrichtung, beispielsweise einer angereihten, gleichartigen Tragschiene, eingesteckt werden können. Der Kühlkörper 8 besitzt eine flache Quader- oder Plattenform und dient der Ableitung von Verlustwärme. Dazu ist er wasser- oder luftgekühlt, wofür die Anschlussstutzen 9, 10 für die Zu- und Ableitung von externem Kühlmedium zur Verfügung stehen.

In analoger Weise überragen die elektrischen Verbindungsschienen 2 den erstgenannten Querrand 11 jeweils mit einem Überstand 12, während sie vom zweiten, gegenüberliegenden Querrand 16 nach innen leicht versetzt sind. Dadurch lässt sich eine Verbindung mit überstehenden Abschnitten elektrischer Verbindungsschienen einer benachbarten, gleichartigen Tragschiene bewerkstelligen.

Gemäß Figur 3 ist ein Einzelgerätemodul 17 über eine geräteeigene Klammer 18, welche die am Schienengrundkörper 1 befestigte Hutschiene 6 hintergreift, mechanisch befestigt. Dabei geraten Kontaktelemente 19, beispielsweise Federstifte oder Kontaktklammern, des Einzelgerätemoduls 17 in elektrisch leitendem Kontakt mit den elektrischen Verbindungsschienen 2 der Tragschiene. Gleichzeitig kommt ein interner Gerätekühlkörper 20, auf dem Leistungshalbleiter oder sonstige Leistungselektronikkomponenten montiert sein können, mit seiner der Tragschiene zugewandten Außenseite zur Anlage auf der gegenüberliegend zugeordneten Außenseite 21 (siehe Figur 1) des Tragschienen-Kühlkörpers 8. Die Außenseite 21 des Tragschienen-Kühlkörpers bildet gleichsam eine Wärmeübertragungswandung, woran die zugeordnete Wärmeübertragungswandung des Gerätekühlkörpers 20 satt anliegen und dabei Verlustwärme abführen kann.

Gemäß Figur 4 sind mehrere Schienengrundkörper 1a, 1b aneinandergereiht, wobei die elektrischen Verbindungsschienen 2 der unterschiedlichen Tragschienen über Stecker, Kontaktfedern, Schrauben oder dergleichen miteinander verbunden und dabei elektrisch hintereinander geschalten sind. Analoges gilt für eine Mehrzahl Kühlkörper 8a, 8b, ... unterschiedlicher, aneinander gereihter Tragschienen. Insbesondere bei der Verwendung von flüssigem Kühlmedium können zur Verbindung der Kühlkörper 8a, 8b, ... Verschraubungen, Schläuche oder sonstige Flüssigkeits-Schnellverbinder eingesetzt werden. Dadurch ist es möglich, eine Mehrzahl Einzelgerätemodule 17a, 17b, ... 17n auf einer modular aus einzelnen Tragschienenmodulen zusammengesetzten "Systemschiene" zu halten und gleichzeitig elektrisch zu verbinden. Letztere kann horizontal oder auch gemäß Zeichnung vertikal angeordnet sein, wobei Figur 4 die Montage der Einzelgerätemodule 17a, 17b, ..., 17n in einer Vorderansicht zeigt. Die Einzelgerätemodule 17a, 17b, ... sind mittels Spann- oder Befestigungsschrauben 22 auf den jeweiligen Tragschienen fixiert, wobei die Schrauben 22 mit der aus mehreren Einzelabschnitten zusammengesetzten Hutschiene 6a, 6b in Eingriff stehen können.

### Bezugszeichenliste

- 1: Schienen-Grundkörper
- 2: elektrische Verbindungsschienen
- 3: Starkstrombus
- 4: Schwachstrombus
- 5: Längsrand
- 6, 6a, 6b: Hutschiene
- 7: Kühleinrichtung
- 8: Kühlkörper
- 9: Anschlussstutzen für Rücklauf
- 10: Anschlussstutzen für Vorlauf
- 11: Querrand
- 12: Überstand
- 13: Stirnseite
- 14, 15: buchsenartige Stutzenaufnahmen
- 16: zweiter Querrand
- 17, 17a, 17b, ...17n: Einzelgerätemodul
- 18: Klammer
- 19: Kontaktelement
- 20: Gerätekühlkörper
- 21: Außenseite/Kühlwandung des Tragschienen-Kühlkörpers
- 22: Schrauben

## Patentansprüche

1. Anordnung mit einer Tragschiene und mit wenigstens einem an der Tragschiene gehaltertem elektrischen Gerät (17,17a,17b,...), wobei die Tragschiene zur Halterung eines oder mehrerer, elektrischer Geräte (17,17a,17b,....) ausgebildet ist, wenigstens einen elektrischen Bus (3,4) zur Leistungs- und/oder Signalübertragung an das eine oder die mehreren elektrischen Geräte (17,17a,17b,...) aufweist und mit wenigstens einer von Kühlmedium durchströmbaren Kühleinrichtung (7) versehen ist, die Verbindungselemente (9,10) für den Zu- und Abgang des Kühlmediums aufweist und mit von extern kontaktierbaren Wärmeübertragungsmitteln (21) gestaltet ist, über welche das oder die Geräte (17,17a,17b,...) mit der Kühleinrichtung (7) thermisch gekoppelt sind, wobei die Wärmeübertragungsmittel (21) eine oder mehrere Wärmeübertragungswandungen (21) aufweisen, **dadurch gekennzeichnet, dass** das oder die elektrischen Geräte (17,17a,17b,...) als Leistungselektronik-Komponenten ausgeführt sind, und an der einen oder den mehreren Wärmeübertragungswandungen (21) ein oder mehrere komplementäre Wärmeübertragungswandungen des oder der Leistungselektronik-Komponenten über Befestigungsmittel (18,6) in Anlage oder sonstiger kraft- und/oder formschlüssiger Verbindung gebracht oder gehalten sind.

2. Anordnung nach Anspruch 1, **gekennzeichnet durch** mehrere in Kühlmedium-Strömungsrichtung hintereinander verbundene Tragschienen mit wenigstens je einer Kühleinrichtung (7a,7b,...), welche parallel mit einem oder mehreren Kühlkanälen thermisch gekoppelt sind, welche sich über die mehreren Tragschienen erstrecken.

3. Anordnung nach Anspruch 2, **dadurch gekennzeichnet, dass** der eine oder die mehreren Kühlkanäle die mehreren Kühleinrichtungen (7a,7b,...) durchsetzen.

4. Anordnung nach Ansprüche 2 oder 3, **dadurch gekennzeichnet, dass** für das Kühlmedium wenigstens eine Quelle und Senke angeordnet, woran der eine oder die mehreren Kühlkanäle gemeinschaftlich angeschlossen sind.

5. Anordnung nach einem der vorangehenden Ansprüche, **gekennzeichnet** lurch zwischen zwei aneinander liegenden Wärmeübertragungswandungen (21) befindliche Mittel zur Verringerung des Wärme-Übergangswiderstands.

6. Anordnung nach einem der vorangehenden Ansprüche, **gekennzeichnet durch** wenigstens eine wärmeübertragende Steckverbindung zwischen der Kühleinrichtung (7) und einem zugeordneten Gerät (17).

7. Anordnung nach Anspruch 6, **dadurch gekennzeichnet, dass** die Steckverbindung zum Austausch flüssigen Kühlmediums zwischen der Kühleinrichtung (7) auf der Tragschiene und dem gehalterten elektrischen Gerät (17) ausgebildet ist.

8. Anordnung nach Anspruch einem der vorangehenden Ansprüche, **dadurch gekennzeichnet, dass** die Kühleinrichtung (7) einen wärmeleitenden Kühlkörper (8) mit quaderartiger oder zylindrischer Grundform jeweils mit einer Kühlwandung (21) zur Anlage des oder der Geräte (17,17a,17b,...) aufweist.

9. Anordnung nach einem der vorangehenden Ansprüche, **dadurch gekennzeichnet, dass** die Kühleinrichtung von einem oder mehreren, zu den Verbindungselementen (9,10) führenden Kühlkanälen durchsetzt ist.

10. Anordnung nach Anspruch 9, **dadurch gekennzeichnet, dass** die Kühlkanäle und/oder Verbindungselemente (9,10) parallel zur geometrischen Erstreckungsrichtung des elektrischen Übertragungsbus (3,4) verlaufen.

11. Anordnung nach Ansprüche 9 oder 10, **dadurch gekennzeichnet, dass** mehrere Kühleinrichtungen (7) parallel mit mindestens einem Kühlkanal thermisch gekoppelt sind.

12. Anordnung nach Anspruch 11, **dadurch gekennzeichnet, dass** ein oder mehrere Kühlkanäle mehrere Kühleinrichtungen (7a,7b) hintereinander in und/oder entgegen der Kühlmedium-Strtimungsrichtung durchsetzen.

13. Anordnung nach einem der Ansprüche 9 bis 12, **dadurch gekennzeichnet, dass** wenigstens zwei Kühlkanäle zum Vor- und Rücklauf für Kühlmedium angeordnet sind.

14. Anordnung nach einem der vorangehenden Ansprüche, **dadurch gekennzeichnet, dass** das oder die Verbindungselemente (9,10) als von der Kühleinrichtung vorspringende Anschlussstutzen und/oder rohrartige Verlängerungen von Kühlkanälen in der Kühleinrichtung ausgebildet sind.

15. Anordnung nach einem der vorangehenden Ansprüche, **gekennzeichnet durch** eine Ausbildung als Modul oder Teilabschnitt für ein modulares Tragschienensystem mit mehreren koppelbaren Tragschienen als Einzelmodule, wobei die Verbindungselemente (9,10) an gegenüber liegenden oder unterschiedlichen Seiten (13) oder Abschnitten der Kühleinrichtung (8 7) angeordnet, und einander an den unterschiedlichen Seiten (13) oder Abschnitten gegenüberliegende Verbindungselemente (9,10) zueinander komplementär ausgebildet sind.

16. Anordnung nach Anspruch 14 und 15, **dadurch gekennzeichnet, dass** eine Seite oder Wandung (13) der Kühleinrichtung (7) mit Mitteln (14,15) zur Aufnahme und zum Anschluss eines oder mehrerer Anschlussstutzen oder sonstiger vorspringender Verbindungselemente (9,10) benachbarter modularer Tragschienen an einem oder mehrere interne Kühlkanäle ausgebildet ist.

17. Anordnung nach Anspruch 16, **dadurch gekennzeichnet, dass** das oder die Aufnahmemittel (14,15) zumindest auf einer Seite (13) der Kühleinrichtung (7) buchsenartig ausgebildet und/oder mit Abstand gegenüber einem nächstliegenden Rand (16) der Tragschiene nach innen versetzt angeordnet sind.

18. Anordnung nach einem der Ansprüche 15 bis 17, **dadurch gekennzeichnet, dass** der oder die Anschlussstutzen zumindest auf einer Seite der Kühleinrichtung (7) über den Rand (11) der Tragschiene hinausragen.

19. Anordnung nach einem der vorangehenden Ansprüche, **gekennzeichnet durch** derart angeordnete und zum Eingriff in die oder an den Geräten (17,17a,17b,...) ausgebildete Geräte/Bauteile-Befestigungsmittel (6), dass bei Eingriff der Befestigungsmittel (6) wenigstens eines der Geräte (17,17a,17b,...) in wärmeübertragender Verbindung oder Kopplung mit der Kühleinrichtung (7) steht.

20. Anordnung nach einem der vorangehenden Ansprüche, **dadurch gekennzeichnet, dass** die Kühleinrichtung (7) ein oder mehrere Anschlusselemente zur Verbindung mit dem Gerät oder Bauteil aufweist.

21. Anordnung nach einem der vorangehenden Ansprüche, **gekennzeichnet durch** einen plattenartigen und/oder flachen Schienen-Grundkörper (1), worin die Kühleinrichtung (7) vertieft eingelassen ist.

22. Anordnung nach einem der vorangehenden Ansprüche, **gekennzeichnet durch** eine wärmeisolierende Abdeckung für das oder die Geräte und/oder die Kühleinrichtung (7) als Berührschutz.

## Claims

1. Arrangement having a support rail and having at least one electrical appliance (17, 17a, 17b, ...) mounted on the support rail, wherein the support rail is formed for mounting one or more electrical appliances (17, 17a, 17b, ...), has at least one electrical bus (3, 4) for transmitting power and/or signals to the one or more electrical appliances (17, 17a, 17b, ...) and is provided with at least one cooling device (7) through which coolant may flow and which has connecting elements (9, 10) for the supply and discharge of the coolant and is formed with heat transmission means (21) contactable from the exterior, via which the appliance(s) (17, 17a, 17b, ...) is/are thermally coupled to the cooling device (7), wherein the heat transmission means (21) have one or more heat transmission walls (21), **characterised in that** the electrical appliance(s) (17, 17a, 17b, ...) is/are formed as electronic power components, and one or more complementary heat transmission walls of the electronic power component(s) is/are brought into or held in contact or other non-positive or positive connection with the one or more heat transmission walls (21) via fixing means (18, 6).

2. Arrangement according to claim 1, **characterised by** plural support rails which are connected in sequence in the direction of flow of the coolant and are each connected to at least one cooling device (7a, 7b, ...), are thermally coupled in parallel to one or more cooling channels, which extend over the plural support rails.

3. Arrangement according to claim 2, **characterised in that** the one or more cooling channels penetrate the plural cooling devices (7a, 7b, ...).

4. Arrangement according to claims 2 or 3, **characterised in that** for the coolant at least one source and drain are provided, to which the one or more cooling channels is/are connected in common.

5. Arrangement according to one of the preceding claims, **characterised by** means located between two adjacent heat transmission walls (21) for reducing the heat transmission resistance

6. Arrangement according to one of the preceding claims, **characterised by** at least one heat-transmitting plug connection between the cooling device (7) and an allocated appliance (17).

7. Arrangement according to claim 6, **characterised in that** the plug connection is formed for the exchange of liquid coolant between the cooling device (7) on the support rail and the mounted electrical appliance (17).

8. Arrangement according to one of the preceding claims, **characterised in that** the cooling device (7) has a heat-conducting cooling body (8) with a cuboid or cylindrical basic shape in each case with a cooling wall (21) for contact with the appliance(s) (17, 17a, 17b, ...).

9. Arrangement according to one of the preceding claims, **characterised in that** the cooling device is penetrated by one or more cooling channels leading to the connecting elements (9, 10).

10. Arrangement according to claim 9, **characterised in that** the cooling channels and/or connecting elements (9, 10) extend parallel to the geometric direction of extension of the electrical transmission bus (3, 4).

11. Arrangement according to claims 9 or 10, **characterised in that** plural cooling devices (7) are coupled thermally in parallel to at least one cooling channel.

12. . Arrangement according to claim 11, **characterised in that** one or more cooling channels penetrate plural cooling devices (7a, 7b) consecutively in and/or opposite to the flow direction of the coolant.

13. Arrangement according to one of claims 9 to 12, **characterised in that** at least two cooling channels are provided for the supply and discharge of coolant.

14. Arrangement according to one of the preceding claims, **characterised in that** the connecting element(s) (9, 10) is/are formed as connecting nozzles projecting from the cooling device and/or as tubular extensions of cooling channels in the cooling device.

15. Arrangement according to one of the preceding claims, **characterised by** an embodiment as a module or component for a modular support rail system having plural support rails capable of being coupled as individual modules, wherein the connecting elements (9, 10) are disposed on opposite or different sides (13) or sections of the cooling device (8, 7), and are formed so as to be complementary to one another on the different sides (13) or sections of opposite connecting elements (9, 10).

16. Arrangement according to claim 14 and 15, **characterised in that** one side or wall (13) of the cooling device (7) is formed with means (14, 15) for receiving and connecting one or more connecting nozzles or other projecting connecting elements (9, 10) of adjacent modular support rails to one or more internal cooling channels.

17. Arrangement according to claim 16, **characterised in that** the receiving means (14, 15) is/are formed at least on the side (13) of the cooling device (7) as a bush and/or is/are disposed with clearance from and offset inwards with respect to a nearest edge (16) of the support rail.

18. Arrangement according to one of claims 15 to 17, **characterised in that** the connecting nozzle(s) project(s) beyond the edge (11) of the support rail at least on one side of the cooling device (7).

19. Arrangement according to one of the preceding claims, **characterised by** fixing means (6) for appliances/components which are so disposed and formed for engagement in or on the appliances (17, 17a, 17b, ...) that upon engagement of the fixing means (6) at least one of the appliances (17, 17a, 17b, ...) is connected or coupled to the cooling device (7).

20. Arrangement according to one of the preceding claims, **characterised in that** the cooling device (7) has one or more connecting elements for connecting with the appliance or component.

21. Arrangement according to one of the preceding claims, **characterised by** a plate-like and/or flat rail base body (1), into which the cooling device (7) is countersunk.

22. Arrangement according to one of the preceding claims, **characterised by** a heat-insulating cover for the appliance(s) and/or the cooling device (7) to prevent manual contact.

## Revendications

1. Installation comprenant un rail support et au moins un appareil électrique (17, 17a, 17b,...) maintenu sur le rail support, dans laquelle le rail support est conçu pour supporter un ou plusieurs appareils électriques (17, 17a, 17b,...), comporte au moins un bus électrique (3, 4) destiné à la transmission de puissance et/ou de signaux à l'appareil ou aux appareils électriques (17, 17a, 17b,...), et comporte au moins un dispositif de refroidissement (7) à travers lequel peut circuler un agent réfrigérant, qui présente des éléments de raccord (9, 10) pour l'entrée et la sortie de l'agent réfrigérant et qui est équipé de moyens de transmission de chaleur (21) pouvant être activés depuis l'extérieur, via lesquels le ou les appareils (17, 17a, 17b,...) sont couplés thermiquement avec le dispositif de refroidissement (7), les moyens de transmission de chaleur (21) présentant une ou plusieurs parois de transmission de chaleur (21), **caractérisée en ce que** le ou les appareils électriques (17, 17a, 17b,...) sont conçus en tant que composants d'électronique de puissance, et **en ce qu'**au niveau d'une ou de plusieurs parois de transmission de chaleur (21), une ou plusieurs parois de transmission de chaleur complémentaires du ou des composants de l'électronique de puissance sont amenées ou maintenues en position, ou mises en relation par une autre liaison de type adhérence et/ou mécanique via des moyens de fixation (18, 6).

2. Installation selon la revendication 1, **caractérisée par** plusieurs rails supports, reliés les uns derrière les autres dans le sens d'écoulement de l'agent réfrigérant, et comportant respectivement un dispositif de refroidissement (7a, 7b, ...), qui sont couplés thermiquement en parallèle avec un ou plusieurs canaux de refroidissement qui s'étendent sur les différents rails supports.

3. Installation selon la revendication 2, **caractérisée en ce que** le ou les canaux de refroidissement traversent les différents dispositifs de refroidissement (7a, 7b, ...).

4. Installation selon la revendication 2 ou 3, **caractérisée en ce que** pour l'agent réfrigérant sont disposés au moins une source et un collecteur, auxquels le ou les canaux de refroidissement sont raccordés collectivement.

5. Installation selon l'une des revendications précédentes, **caractérisée par** des moyens de réduction de la résistance à la transmission de chaleur, qui se trouvent entre deux parois de transmission de chaleur (21) contiguës.

6. Installation selon l'une des revendications précédentes, **caractérisée par** au moins une connexion par fiche transmettant la chaleur entre le dispositif de refroidissement (7) et un appareil coordonné (17).

7. Installation selon la revendication 6, **caractérisée en ce que** la connexion par fiche est conçue pour échanger l'agent réfrigérant liquide entre le dispositif de refroidissement (7) sur le rail support et l'appareil électrique (17) maintenu dessus.

8. Installation selon l'une des revendications précédentes, **caractérisée en ce que** le dispositif de refroidissement (7) présente un dissipateur de chaleur (8) thermoconducteur ayant une forme de base rectangulaire ou cylindrique avec respectivement une paroi de refroidissement (21) pour le positionnement du ou des appareils (17, 17a, 17b, ...).

9. Installation selon l'une des revendications précédentes, **caractérisée en ce que** le dispositif de refroidissement est traversé par un ou plusieurs canaux de refroidissement menant aux éléments de raccord (9, 10).

10. Installation selon la revendication 9, **caractérisée en ce que** les canaux de refroidissement et/ou les éléments de raccord (9, 10) s'étendent parallèlement au sens d'extension géométrique du bus de transmission électrique (3, 4).

11. Installation selon la revendication 9 ou 10, **caractérisée en ce que** plusieurs dispositifs de refroidissement (7) sont couplés thermiquement en parallèle avec au moins un canal de refroidissement.

12. Installation selon la revendication 11, **caractérisée en ce qu'**un ou plusieurs canaux de refroidissement traversent plusieurs dispositifs de refroidissement (7a, 7b) les uns derrière les autres dans le sens ou à contresens de l'écoulement de l'agent réfrigérant.

13. Installation selon l'une des revendications 9 à 12, **caractérisée en ce qu'**au moins deux canaux de refroidissement sont disposés pour l'avance et le reflux de l'agent réfrigérant.

14. Installation selon l'une des revendications précédentes, **caractérisée en ce que** le ou les éléments de raccord (9, 10) sont conçus sous forme de raccords dépassant du dispositif de refroidissement et/ou de prolongements tubulaires des canaux de refroidissement dans le dispositif de refroidissement.

15. Installation selon l'une des revendications précédentes, **caractérisée par** une conception modulaire ou segmentée pour un système modulaire de rails supports comportant plusieurs rails supports qui peuvent être accouplés en tant que modules séparés, dans laquelle les éléments de raccord (9, 10) sont disposés au niveau de côtés (13) opposés ou différents ou de segments du dispositif de refroidissement (7), et en ce que des éléments de raccord (9, 10) opposés les uns aux autres sur les différents côtés (13) ou segments sont formés pour être complémentaires les uns des autres.

16. Installation selon la revendication 14 ou 15, **caractérisée en ce qu'**un côté ou une paroi (13) du dispositif de refroidissement (7) est conçu avec des moyens (14, 15) de réception et de raccordement d'un ou de plusieurs raccords ou autres éléments de raccord (9, 10) faisant saillie de rails supports modulaires voisins au niveau d'un ou de plusieurs canaux de refroidissement internes.

17. Installation selon la revendication 16, **caractérisée en ce que** le ou les moyens de réception (14, 15) sont conçus sous forme de douilles au moins sur un côté (13) du dispositif de refroidissement (7) et/ou sont disposés de façon décalée vers l'intérieur à distance du bord immédiatement suivant (16) du rail support.

18. Installation selon l'une des revendications 15 à 17, **caractérisée en ce que** le ou les raccords dépassent au-delà du bord (11) des rails supports au moins sur un côté du dispositif de refroidissement (7).

19. Installation selon l'une des revendications précédentes, **caractérisée par** des moyens de fixation d'appareils-composants (6) formés pour s'engrener dans ou contre le ou les appareils (17, 17a, 17b, ...) et disposés de façon à ce que lors de l'engrènement des moyens de fixation (6), au moins un des appareils (17, 17a, 17b, ...) se trouve en relation de transmission thermique ou de couplage thermique avec le dispositif de refroidissement (7).

20. Installation selon l'une des revendications précédentes, **caractérisée en ce que** le dispositif de refroidissement (7) présente un ou plusieurs éléments de raccordement pour la liaison à l'appareil ou au composant.

21. Installation selon l'une des revendications précédentes, **caractérisée par** un corps de base du rail de type plat et/ou plaque (1), dans lequel le dispositif de refroidissement (7) est enfoncé en retrait.

22. Installation selon l'une des revendications précédentes, **caractérisée par** un revêtement calorifuge du ou des appareils et/ou du dispositif de refroidissement (7) en tant que protection contre le contact.
